# EUROPEAN PATENT SPECIFICATION

(11) **EP 2 871 918 B1**
(45) Date of publication and mention of the grant of the patent: **08.09.2021**
(21) Application number: 13813816.9
(22) Date of filing: 04.07.2013
(51) Int. Cl.: H05K 1/05, H01L 23/498, H01L 23/373, H01L 23/14, H05K 1/03

(54) **LAMINATE FOR CIRCUIT BOARDS, METAL-BASED CIRCUIT BOARD, AND POWER MODULE**
LAMINAT FÜR LEITERPLATTEN, LEITERPLATTE AUF METALLBASIS UND STROMMODUL
STRATIFIÉ POUR CARTES DE CIRCUIT IMPRIMÉ, CARTE DE CIRCUIT IMPRIMÉ À BASE DE MÉTAL, ET MODULE D'ÉNERGIE ÉLECTRIQUE

(30) Priority: 06.07.2012 JP 2012152970
(43) Date of publication of application: 13.05.2015
(73) Proprietor: NHK Spring Co., Ltd., Yokohama-shi, Kanagawa 236-0004 (JP)
(72) Inventor: MIZUNO, Katsumi, Yokohama-shi Kanagawa 236-0004 (JP); KONOMI, Kazuhiko, Yokohama-shi Kanagawa 236-0004 (JP); NATSUME, Yutaka, Yokohama-shi Kanagawa 236-0004 (JP)
(74) Representative: Zech, Stefan Markus
(86) International application number: PCT/JP2013/068361
(87) International publication number: WO 2014/007327

(56) References cited:
- JP-A- H1 112 463
- JP-A- 2010 174 242
- JP-A- 2011 249 606
- KR-A- 20100 103 942
- US-B1- 6 265 767
- None

## Description

### TECHNICAL FIELD

The present invention relates to a circuit board laminate, a metal base circuit board manufactured from the circuit board laminate and a power module including the metal base circuit board.

### BACKGROUND ART

The progress of electronics technology in recent years is remarkable, and electrical and electronic equipments continue to rapidly become more sophisticated and smaller. In accordance therewith, the amount of heat generation from components in which an electrical element and/or an electronic element are/is mounted is becoming larger and larger. In this situation, satisfactory heat resistance and excellent heat dissipating properties are required for metal base circuit boards in which so-called power devices whose typical examples are MOSFET (metal-oxide-semiconductor field-effect transistor), IGBT (insulated-gate bipolar transistor) and the like are mounted. Particularly in the future, SiC (silicon carbide) devices will be increasingly employed. The operating temperature of such devices is much higher than that of the conventional Si (silicon) devices, so that requirement for enhanced heat resistance is anticipated. Moreover, the stress by heat cycle in solder connection areas in which a power device is connected to a metal base circuit board tends to increase, so that it is becoming difficult to ensure durability and solder connection reliability.

Meanwhile, a resin composition comprising a cyanate resin is generally known as a highly heat-resistant resin composition. For example, patent references 1 to 4 disclose a highly heat-resistant prepreg obtained by impregnating a base material with a composition comprising a cyanate resin, and a heat conductive substrate including a heat transfer sheet layer composed of a product of curing of a composition comprising a cyanate resin.

Further, patent reference 5 discloses a multi-layer printed wiring board comprising an insulating sheet in which a cyanate resin is incorporated, the insulating sheet capable of maintaining a high elastic modulus even at high temperatures.
US 6 265 767 B1 discloses a circuit board laminate according to the preamble of claim 1. JP H11 12463 A discloses a resin composition for printed circuit boards. JP 2010 174242 A discloses a biphenyl aralkyl amine-type cyanic-acid ester resin used for a resin composition for prepreg.

### CITATION LIST

### PATENT LITERATURE

Patent reference 1: Jpn. Pat. Appln. KOKAI Publication No. (hereinafter referred to as JP-A-) 2011-116910,
Patent reference 2: JP-A-2005-272573,
Patent reference 3: JP-A-2010-31263,
Patent reference 4: JP-A-2008-098489, and
Patent reference 5: JP-A-2004-202895.

### DISCLOSURE OF INVENTION

### TECHNICAL PROBLEM

The metal base circuit board has a structure in which an insulating layer and a circuit pattern are sequentially superimposed on at least one surface of a metal substrate. The current situation is that even when the above-mentioned known composition comprising a cyanate resin is used as a resin composition constituting the insulating layer, it is difficult to manufacture a metal base circuit board that excels in heat resistance, durability and solder connection reliability and ensures long-term reliability.

It is an object of the present invention to provide a circuit board laminate from which a metal base circuit board that excels in heat resistance, durability and solder connection reliability and ensures long-term reliability can be manufactured. It is another object of the present invention to provide a metal base circuit board that excels in heat resistance, durability and solder connection reliability and ensures long-term reliability, the metal base circuit board manufactured from the above circuit board laminate. It is a further object of the present invention to provide a power module including this metal base circuit board.

### SOLUTION TO PROBLEM

In the first aspect of the present invention, there is provided a circuit board laminate according to claim 1.

In the present invention, the bisphenol cyanate resin and the novolac cyanate resin are contained in the insulating layer in a mass ratio of 11:1 to 1:3.

The insulating layer comprises, for example, at least one member selected from the group consisting of alumina, surface-treated alumina, aluminum nitride and boron nitride as the inorganic filler.

According to the present invention, the insulating layer further comprises a curing accelerator. The curing accelerator is, for example, a borate complex, and the borate complex may be a phosphorus borate complex or a nonphosphorus borate complex.

In another embodiment of the present invention, the insulating layer comprises, as the curing accelerator, a phosphorus borate complex and, as the inorganic filler, at least one member, preferably two or more members, selected from the group consisting of surface-treated alumina, aluminum nitride and boron nitride.

In a further embodiment of the present invention, the insulating layer comprises, as the curing accelerator, a nonphosphorus borate complex and, as the inorganic filler, at least one member, preferably two or more members, selected from the group consisting of alumina, surface-treated alumina, aluminum nitride and boron nitride.

In the second aspect of the present invention, there is provided a metal base circuit board obtained by patterning the metal foil included in the above circuit board laminate.

In the third aspect of the present invention, there is provided a power module comprising the above metal base circuit board.

### ADVANTAGEOUS EFFECTS OF INVENTION

The present invention has made it feasible to provide a metal base circuit board that excels in heat resistance, durability and solder connection reliability and ensures long-term reliability. Further, the present invention has made it feasible to provide a power module including this metal base circuit board.

### BRIEF DESCRIPTION OF DRAWINGS

FIG. 1 is a diagrammatic perspective view of a circuit board laminate according to one embodiment of the present invention.
FIG. 2 is a view of section along line II-II of the circuit board laminate of FIG. 1.
FIG. 3 is a diagrammatic section view of one form of metal base circuit board obtained from the circuit board laminate of FIGS. 1 and 2.
FIG. 4 is a diagrammatic section view of a power module according to one embodiment of the present invention.
FIG. 5 is a diagrammatic section view of the conventional power module.

### DESCRIPTION OF EMBODIMENTS

Embodiments of the present invention will be described in detail below with reference to appended drawings.

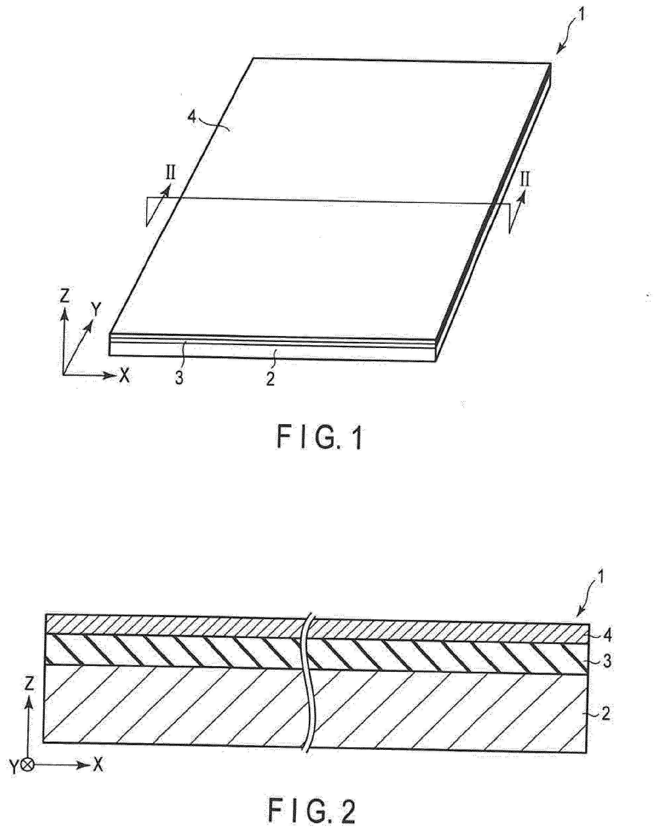

The circuit board laminate 1 of FIGS. 1 and 2 has a three-layer structure in which an insulating layer 3 is superimposed on a major surface of a metal substrate 2 and in which a metal foil 4 is superimposed on the insulating layer 3. In another embodiment of the present invention, the circuit board laminate 1 may have a five-layer structure in which insulating layers 3 are superimposed on both major surfaces of a metal substrate 2 and in which metal foils 4 are superimposed on the insulating layers 3. In FIGS. 1 and 2, the X- and Y-directions are parallel to the major surfaces of the metal substrate 2 and are perpendicular to each other. The Z-direction is a thickness direction perpendicular to the X- and Y-directions. Although FIG. 1 shows a rectangular form as an example of the circuit board laminate 1, the circuit board laminate 1 may assume other forms.

The insulating layer comprises a bisphenol cyanate resin, a novolac cyanate resin and an inorganic filler. The primary feature of the invention is that the bisphenol cyanate resin and the novolac cyanate resin constitute a crosslinked copolymer.

Cyanate resins even of the same kind exhibit varied glass transition temperatures (Tg) of curing product and mechanical properties, depending on the type of molecular structure thereof. For example, desired high heat resistance and high toughness cannot be attained only by simply using a highly heat-resistant resin together with a highly tough resin in order to enhance the heat resistance and toughness of the insulating layer. A highly heat-resistant insulating layer excelling in toughness can be provided by forming a crosslinked copolymer of highly tough bisphenol cyanate resin and novolac cyanate resin whose glass transition temperature is high. The reason therefor is presumed to be that higher glass transition temperature than in the use of bisphenol type alone can be realized by the formation of a blend of novolac cyanate resin and bisphenol cyanate resin into a crosslinked copolymer structure, while higher toughness than in the use of novolac type alone can be realized by the addition of a flexible structure of bisphenol cyanate resin to the crosslink structure of novolac cyanate resin. The performance (hereinafter also referred to as "heat cycle performance") of indirectly relaxing any stress by heat cycle in solder connection areas of the insulating layer can be enhanced by the realization of enhanced toughness and low elasticity. As a result, the solder connection reliability can be enhanced.

Moreover, in the system comprised of a blend of bisphenol cyanate resin and novolac cyanate resin, the advance of curing reaction (cyclization trimerization reaction) at melting is facilitated by melting point depression, so that substantially no unreacted groups remain. As a result, the long-term reliability (for example, solder connection reliability) can be enhanced. Still further, the system comprised of a blend of bisphenol cyanate resin and novolac cyanate resin exhibits a low elasticity. This also enhances the heat cycle performance of the insulating layer and contributes toward the enhancement of solder connection reliability.

Examples of the bisphenol cyanate resins for use in the present invention include a bisphenol A cyanate resin, a bisphenol E phenol resin a tetramethylbisphenol F cyanate resin and the like. The weight average molecular weight of bisphenol cyanate resin is not particularly limited. The bisphenol cyanate resin may be an oligomer or a monomer.

With respect to the bisphenol cyanate resins for use in the present invention, for example, a tetramethylbisphenol F cyanate resin, a bisphenol A cyanate resin and a bisphenol E cyanate resin are preferred in this order from the viewpoint of heat resistance. From the viewpoint of reactivity, a bisphenol A cyanate resin is preferred.

Examples of the novolac cyanate resins for use in the present invention include a phenol novolac cyanate resin, a cresol novolac cyanate resin and the like. The weight average molecular weight of novolac cyanate resin is not particularly limited. The novolac cyanate resin may be an oligomer or a monomer.

With respect to the bisphenol cyanate resins for use in the present invention, for example, a phenol novolac cyanate resin is preferred from the viewpoint of reactivity.

The bisphenol cyanate resin and the novolac cyanate resin are contained in the insulating layer according to the present invention in a mass ratio of 11:1 to 1:3, preferably 3:1 to 1:3 and further more preferably 2.5:1 to 1:2. When the ratio of bisphenol cyanate resin contained is extremely large, the glass transition temperature (Tg) occasionally becomes so low as to disenable the attainment of desired heat resistance. On the other hand, when the ratio of novolac cyanate resin contained is extremely large, the toughness becomes poor. This is also unfavorable from the viewpoint of reactivity.

The insulating layer contains an inorganic filler together with the bisphenol cyanate resin and the novolac cyanate resin. Examples of the inorganic fillers include alumina, aluminum nitride, boron nitride, silicon nitride, magnesium oxide, silicon oxide and the like. It is preferred to use one, or two or more members selected from among these.

In the system containing an inorganic filler, the exothermic reaction accompanying the curing tends to be inhibited by the presence of the inorganic filler. In the system in which the bisphenol cyanate resin and the novolac cyanate resin constitute a crosslinked copolymer according to the present invention, problems never occurring in systems in which a single resin is used may occur. For example, problems, such as retardation of curing reaction attributed to the absorption of reaction heat by the inorganic filler and inhibition of curing reaction of cyanate groups by the surface functional groups of the inorganic filler, are anticipated. Therefore, use may be made of a surface-treated inorganic filler, and it is preferred to use the inorganic filler in appropriate combination with a curing accelerator to be described hereinafter. The surface treatment of the inorganic filler may be attained by, for example, modifying the surface of the inorganic filler with a functional group capable of chemical bonding to a cyanate resin accompanied by reaction, or with a functional group exhibiting high compatibility to a cyanate resin (as the functional group, there can be mentioned, for example, a cyanate group, an epoxy group, an amino group, a hydroxyl group, a carboxyl group, a vinyl group, a styryl group, a methacrylic group, an acrylic group, a ureido group, a mercapto group, a sulfide group, an isocyanate group or the like) . For example, use is made of silane coupling treatment or plasma treatment.

The content of inorganic filler in the insulating layer according to the present invention is preferably in the range of 50 to 90 vol% based on the total volume of novolac cyanate resin and bisphenol cyanate resin. The content of inorganic filler is more preferably in the range of 60 to 80 vol%. When the content is extremely low, precipitation of the inorganic filler tends to occur. On the other hand, when the content is extremely high, an extremely high viscosity may result to thereby disenable the formation of a uniform coating film, causing an increase of pore defect.

The insulating layer may contain a curing accelerator. The curing accelerator is not particularly limited. For example, a borate complex can be mentioned. The borate complex may be a phosphorus borate complex or a nonphosphorus borate complex.

As the phosphorus borate complex, there can be mentioned, for example, tetraphenylphosphonium tetraphenylborate, tetraphenylphosphonium tetra-p-tolylborate, tri-tert-butylphosphonium tetraphenylborate, di-tert-butylmethylphosphonium tetraphenylborate, p-tolyltriphenylphosphonium tetra-p-tolylborate, tetraphenylphosphonium tetrafluoroborate, triphenylphosphine triphenylborate or the like.

As the nonphosphorus borate complex, there can be mentioned, for example, sodium tetraphenylborate, pyridine triphenylborate, 2-ethyl-4-methylimidazolium tetraphenylborate, 1,5-diazabicyclo[4.3.0]nonene-5-tetraphenylborate, lithium triphenyl(n-butyl)borate or the like.

In one embodiment of the present invention, it is preferred for the insulating layer to contain a phosphorus borate complex as the curing accelerator together with at least one member selected from the group consisting of surface-treated alumina, aluminum nitride and boron nitride as the inorganic filler. It is more preferred to contain a phosphorus borate complex together with at least two members selected from the group consisting of surface-treated alumina, aluminum nitride and boron nitride. In particular, alumina inhibits the curing reaction of cyanate resins (for example, due to adverse effect by steric hindrance of molecular structure). Accordingly, surface-treated alumina is preferably used in the combination with a phosphorus borate complex as the curing accelerator. Inhibition of curing can be prevented by altering the surface of particles in advance.

In another embodiment of the present invention, it is preferred for the insulating layer to contain a nonphosphorus borate complex as the curing accelerator together with at least one member selected from the group consisting of surface-treated alumina, alumina, aluminum nitride and boron nitride as the inorganic filler. It is more preferred to contain a nonphosphorus borate complex together with at least two members selected from the group consisting of surface-treated alumina, alumina, aluminum nitride and boron nitride. When a nonphosphorus borate complex is used as the curing accelerator, the combination with alumina whose surface is not treated can be appropriately employed as compared with the use of a phosphorus borate complex. The mechanism of curing acceleration is not necessarily apparent. However, one reason therefor is presumed to be that a nonphosphorus borate complex exhibits higher activity as a curing accelerator in a system in which aluminum oxide is present than that exhibited by a phosphorus borate complex, so that the adverse effect (for example, steric hindrance of molecular structure) of aluminum oxide on the curing acceleration system in which a nonphosphorus borate complex is used is less.

A curing accelerator is added to the insulating layer according to the present invention, the content thereof being preferably in the range of 0.1 to 5 mass%, more preferably 0.5 to 2 mass%, based on the total mass of novolac cyanate resin and bisphenol cyanate resin.

The insulating layer is a product of curing of a coating film formed from a resin composition (hereinafter also referred to as "composition of the present invention") obtained by dissolving ingredients comprising the above-mentioned bisphenol cyanate resin, novolac cyanate resin and inorganic filler in a solvent. Examples of solvents include N-methylpyrrolidone, dimethylacetamide, tetrafluoroisopropanol, methyl ethyl ketone, ethylene diglycol acetate, propylene glycol monomethyl ether acetate, methyl isobutyl ketone, ethylene glycol monomethyl ether, tetrahydrofuran, chloroform, toluene, xylene, acetone, dioxane, dimethyl sulfoxide and the like.

In the composition used in the present invention, the solid content is preferably in the range of, for example, 1 to 50 mass%, more preferably 15 to 35 mass%. When the amount of solvent is extremely large, it becomes necessary to remove a large amount of solvent from the coating film, thereby tending to invite defective appearance of the coating film. Further, prolonged drying time becomes necessary, thereby causing productivity slowdown. On the other hand, when the amount of solvent is extremely small, the composition tends to have a high viscosity that deteriorates, for example, the handleability thereof.

The composition used in the present invention may comprise various additives other than the above-mentioned bisphenol cyanate resin, novolac cyanate resin, inorganic filler and curing accelerator. Examples of such additives include coupling agents, such as a silane coupling agent and a titanium coupling agent, an ion adsorbent, an antisetting agent, a hydrolysis inhibitor, a leveling agent, an antioxidant and the like.

The metal substrate 2 is comprised of, for example, a simple metal or an alloy. As the material for manufacturing the metal substrate 2, use can be made of, for example, aluminum, iron, copper, an aluminum alloy or stainless steel. The metal substrate 2 may further contain a nonmetal, such as carbon. For example, the metal substrate 2 may contain an aluminum complexed with carbon. Further, the metal substrate 2 may have a monolayer structure or a multilayer structure.

The metal substrate 2 exhibits a high thermal conductivity. The metal substrate 2 typically exhibits a thermal conductivity of 60 W·m⁻¹·K⁻¹ or higher.

The metal substrate 2 may be flexible or nonflexible. The thickness of the metal substrate 2 is, for example, in the range of 0.2 to 5 mm.

The metal foil 4 is superimposed on the insulating layer 3. The metal foil 4 faces the metal substrate 2 with the insulating layer 3 interposed therebetween.

The metal foil 4 is comprised of, for example, a simple metal or an alloy. As the material for manufacturing the metal foil 4, use can be made of, for example, copper or aluminum. The thickness of the metal foil 4 is, for example, in the range of 10 to 500 µm.

This circuit board laminate 1 is manufactured by, for example, the following method.

First, the above-mentioned bisphenol cyanate resin, novolac cyanate resin and curing accelerator are blended together while heating. The blend is dissolved in a solvent to thereby obtain a solution. Subsequently, the above-mentioned inorganic filler is dispersed in the solution to thereby obtain a dispersion. The inorganic filler may be dispersed in the solution while pulverizing the same by means of, for example, a ball mill, a three-roll mill, a centrifugal stirrer or a beads mill. Prior to the dispersion of the inorganic filler in the solution, additives, such as a silane coupling agent and an ion adsorbent, may be added to the solution.

Next, the obtained dispersion is applied to at least either the metal substrate 2 or the metal foil 4. For the application of the dispersion, use can be made of, for example, a roll coat method, a bar coat method or a screen printing method. The application may be performed continuously, or plate by plate (foil by foil).

The resultant coating film is dried according to necessity, and the metal substrate 2 and the metal foil 4 are joined together so that they face each other with the coating film interposed therebetween, followed by hot pressing. Thus, the circuit board laminate 1 is obtained.

In this method, the coating film is formed by applying the dispersion as the composition of the present invention to at least either the metal substrate 2 or the metal foil 4. In another embodiment, a coating film is formed in advance by applying the dispersion to a base material, such as a PET film, and drying the applied dispersion, and thermal transfer of the coating film to at least either the metal substrate 2 or the metal foil 4 is carried out.

Now, the metal base circuit board 1' obtained from the above-described circuit board laminate 1 will be described.

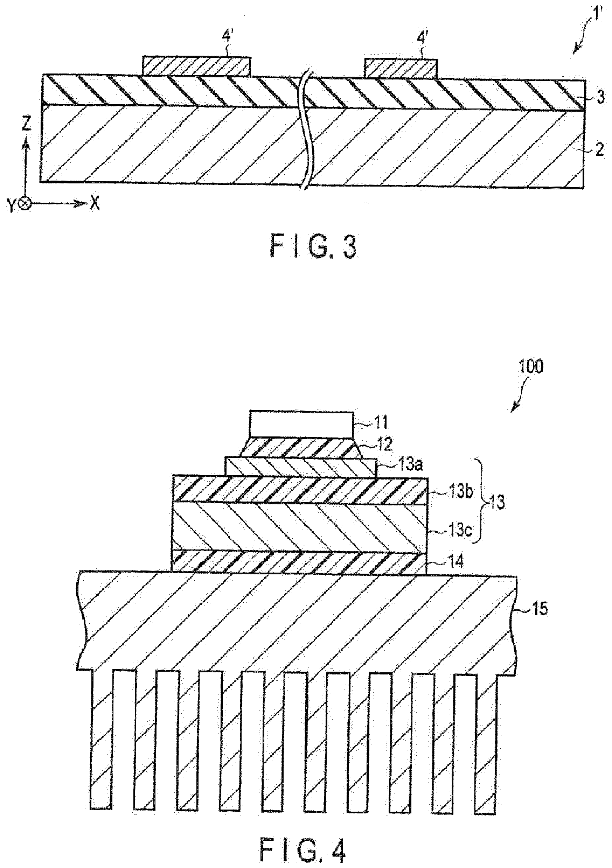

The metal base circuit board 1' of FIG. 3 is obtained from the circuit board laminate 1 of FIGS. 1 and 2, and comprises the metal substrate 2, the insulating layer 3 and the circuit pattern 4'. The circuit pattern 4' is obtained by patterning the metal foil 4 of circuit board laminate described above with reference to FIGS. 1 and 2. This patterning can be accomplished by, for example, forming a mask pattern on the metal foil 4 and etching away any exposed areas of the metal foil 4. The metal base circuit board 1' can be obtained by, for example, patterning the metal foil 4 of the circuit board laminate 1 as mentioned above and, according to necessity, performing processing, such as cutting or drilling.

The thus obtained metal base circuit board 1' is obtained from the circuit board laminate 1 described above, thereby excelling in heat resistance, toughness and solder connection reliability.

FIG. 4 shows a form of power module according to the present invention. The power module 100 comprises the metal base circuit board 13 of the present invention comprising the metal substrate 13c, the insulating layer 13b and the circuit pattern 13a, thereby excelling in heat resistance, durability and solder connection reliability and thus ensuring long-term reliability. Therefore, in the current situation in which the exothermic temperature tends to increase in accordance with the sophistication of power devices, the power module of the present invention can be appropriately used even in a temperature range with which conventional power modules have failed to cope.

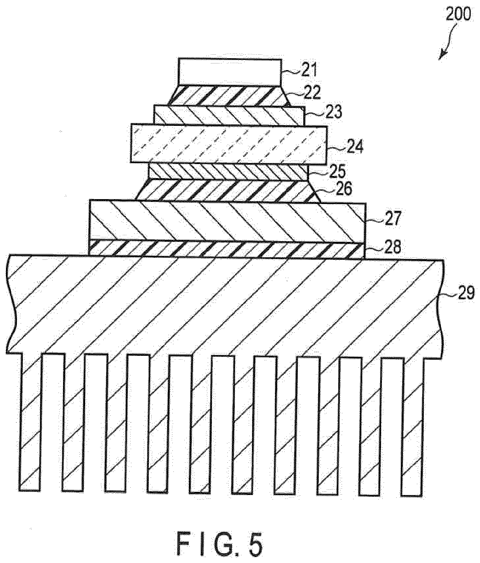

Moreover, the power module 100 of the present invention, as compared with conventional power modules whose one form 200 is shown in FIG. 5, is less in the number of constituent members (layers) by virtue of the incorporation of the metal base circuit board 13, thereby being thin as a whole. Thus, a lower thermal-resistance, compact design can be permitted. Further, the power module 100 of the present invention is advantageous in that processing, such as drilling or cutting, is easy, thereby facilitating the assembly thereof.

### EXAMPLES

Embodiments of the present invention will be described in greater detail below.

### <Preparation of composition>

### Synthetic Example 1: preparation of composition 1

Bisphenol A cyanate resin ("BA200" produced by Lonza Corp.) and phenol novolac cyanate resin ("PT30" produced by Lonza Corp.) were blended together while heating in a mass ratio of 3:1. Phosphorus curing accelerator (tetraphenylphosphonium tetra-p-tolyl borate "TPP-MK" produced by Hokko Chemical Industry Co., Ltd.) was mixed into the blend in an amount of 1 mass% based on the total mass of resins. Dimethylacetamide was added to the resultant resin blend, thereby obtaining a cyanate resin solution of 40 mass% resin solid content. Boron nitride ("HP-40" produced by Mizushima Ferroalloy Co., Ltd.) and aluminum nitride ("FAN-f30" produced by Furukawa Denshi Co. Ltd.) were blended into the solution in a volume ratio of 1:1 so that the total content of the nitrides based on resin solids was 65 vol%. Thus, insulating material solution (composition 1) was obtained.

Synthetic Examples 2 to 5: preparation of compositions 2 to 5
Compositions 2 to 5 were prepared in the same manner as in the preparation of composition 1 except that the blending ratio of bisphenol A cyanate resin ("BA200" produced by Lonza Corp.) and phenol novolac cyanate resin ("PT30" produced by Lonza Corp.) was changed as indicated in Table 3.

Synthetic Example 6: preparation of composition 6 Bisphenol A cyanate resin ("BA200" produced by Lonza Corp.) and phenol novolac cyanate resin ("PT30" produced by Lonza Corp.) were blended together while heating in a mass ratio of 3:1. Phosphorus curing accelerator ("TPP-MK" produced by Hokko Chemical Industry Co., Ltd.) was mixed into the blend in an amount of 1 mass% based on the total mass of resins. Dimethylacetamide was added to the resultant resin blend, thereby obtaining a cyanate resin solution of 40 mass% resin solid content. Boron nitride ("HP-40" produced by Mizushima Ferroalloy Co., Ltd.) and aluminum ("AS40" produced by Showa Denko K.K.) were blended into the solution in a volume ratio of 1:1 so that the total content of the fillers based on resin solids was 65 vol%. Thus, insulating material solution (composition 6) was obtained.

Synthetic Example 7: preparation of composition 7 Bisphenol A cyanate resin ("BA200" produced by Lonza Corp.) and phenol novolac cyanate resin ("PT30" produced by Lonza Corp.) were blended together while heating in a mass ratio of 3:1. Nonphosphorus curing accelerator (diazabicyclononene tetraphenylborate "DBNK" produced by Hokko Chemical Industry Co., Ltd.) was mixed into the blend in an amount of 1 mass% based on the total mass of resins. Dimethylacetamide was added to the resultant resin blend, thereby obtaining a cyanate resin solution of 40 mass% resin solid content. Boron nitride ("HP-40" produced by Mizushima Ferroalloy Co., Ltd.) and aluminum ("AS40" produced by Showa Denko K.K.) were blended into the solution in a volume ratio of 1:1 so that the total content of the fillers based on resin solids was 65 vol%. Thus, insulating material solution (composition 7) was obtained.

Synthetic Example 8: preparation of composition 8
Bisphenol A cyanate resin ("BA200" produced by Lonza Corp.) and phenol novolac cyanate resin ("PT30" produced by Lonza Corp.) were blended together while heating in a mass ratio of 3:1. Phosphorus curing accelerator ("TPP-MK" produced by Hokko Chemical Industry Co., Ltd.) was mixed into the blend in an amount of 1 mass% based on the total mass of resins. Dimethylacetamide was added to the resultant resin blend, thereby obtaining a cyanate resin solution of 40 mass% resin solid content. Boron nitride ("HP-40" produced by Mizushima Ferroalloy Co., Ltd.) and aluminum whose surface was treated with a silane coupling agent ("KBM-103" produced by Shin-Etsu Chemical Co., Ltd.) were blended into the solution in a volume ratio of 1:1 so that the total content of the fillers based on resin solids was 65 vol%. Thus, insulating material solution (composition 8) was obtained.

Synthetic Example 9: preparation of composition 9
Bisphenol A cyanate resin ("BA200" produced by Lonza Corp.) and phenol novolac cyanate resin ("PT30" produced by Lonza Corp.) were blended together while heating in a mass ratio of 3:1. Nonphosphorus curing accelerator ("DBNK" produced by Hokko Chemical Industry Co., Ltd.) was mixed into the blend in an amount of 1 mass% based on the total mass of resins. Dimethylacetamide was added to the resultant resin blend, thereby obtaining a cyanate resin solution of 40 mass% resin solid content. Boron nitride ("HP-40" produced by Mizushima Ferroalloy Co., Ltd.) and aluminum whose surface was treated with a silane coupling agent ("KBM-103" produced by Shin-Etsu Chemical Co., Ltd.) were blended into the solution in a volume ratio of 1:1 so that the total content of the fillers based on resin solids was 65 vol%. Thus, insulating material solution (composition 9) was obtained.

Synthetic Example 10: preparation of composition 10
Bisphenol A cyanate resin ("BA200" produced by Lonza Corp.) and phenol novolac cyanate resin ("PT30" produced by Lonza Corp.) were blended together while heating in a mass ratio of 3:1. Nonphosphorus curing accelerator ("DBNK" produced by Hokko Chemical Industry Co., Ltd.) was mixed into the blend in an amount of 1 mass% based on the total mass of resins. Dimethylacetamide was added to the resultant resin blend, thereby obtaining a cyanate resin solution of 40 mass% resin solid content. Boron nitride ("HP-40" produced by Mizushima Ferroalloy Co., Ltd.) and aluminum nitride ("FAN-f30" produced by Furukawa Denshi Co. Ltd.) were blended into the solution in a volume ratio of 1:1 so that the total content of the nitrides based on resin solids was 65 vol%. Thus, insulating material solution (composition 10) was obtained.

Synthetic Examples 11 to 15: preparation of compositions 11 to 15
Compositions 11 to 15 were prepared in the same manner as in the preparation of composition 1 except that the blending ratio of bisphenol A cyanate resin ("BA200" produced by Lonza Corp.) and phenol novolac cyanate resin ("PT30" produced by Lonza Corp.) was changed as indicated in Table 3.

### Reference Synthetic Example 1: preparation of composition 1R

Bisphenol A cyanate resin ("BA200" produced by Lonza Corp.) was blended with a phosphorus curing accelerator ("TPP-MK" produced by Hokko Chemical Industry Co., Ltd.) amounting to 1 mass% based on the mass of resin. Dimethylacetamide was added to the resultant blend, thereby obtaining a bisphenol A cyanate resin solution of 40 mass% solid content. Boron nitride ("HP-40" produced by Mizushima Ferroalloy Co., Ltd.) and aluminum nitride ("FAN-f30" produced by Furukawa Denshi Co. Ltd.) were blended into the solution in a volume ratio of 1:1 so that the total content of the nitrides based on resin solids was 65 vol%. Thus, insulating material solution (composition 1R) was obtained.

### Reference Synthetic Example 2: preparation of composition 2R

Phenol novolac cyanate resin ("PT30" produced by Lonza Corp.) was blended with a phosphorus curing accelerator ("TPP-MK" produced by Hokko Chemical Industry Co., Ltd.) amounting to 1 mass% based on the mass of resin. Dimethylacetamide was added to the resultant blend, thereby obtaining a phenol novolac cyanate resin solution of 40 mass% solid content. Boron nitride ("HP-40" produced by Mizushima Ferroalloy Co., Ltd.) and aluminum nitride ("FAN-f30" produced by Furukawa Denshi Co. Ltd.) were blended into the solution in a volume ratio of 1:1 so that the total content of the nitrides based on resin solids was 65 vol%. Thus, insulating material solution (composition 2R) was obtained.

### <Evaluation>

### [Glass transition temperature (Tg/°C)]

Each of the insulating material solutions obtained in accordance with the above procedures was agitated for five minutes by means of a planetary stirrer defoaming machine, applied onto a copper foil of 70 µm thickness so that the film thickness after thermobonding was about 100 µm, and dried at 100°C until the solvent was evaporated off. The copper foil coated with the film was superimposed on an aluminum alloy plate of 140 W/mk thermal conductivity and 2.0 mm thickness as a metal substrate with the coating film interposed therebetween, and thermobonded at 250°C (200°C in Comparative Examples 3 and 4) under a pressure of 20 MPa. From the thus obtained circuit board laminate as a sample, only the coating film as an insulating layer was taken out by chemical etching of the copper foil and the aluminum plate.

A sheet of size 5 mm × 50 mm was cut out from the insulating layer obtained in the above manner, and the dynamic viscoelasticity thereof was measured by means of dynamic viscoelasticity measuring instrument (model RSA3 manufactured by TA Instruments) under the conditions of tensile mode, temperature raising rate 2°C/min, measuring temperature range -50 to 400°C, nitrogen atmosphere and measuring frequency 1 Hz. Tan δ was calculated from the thus obtained storage elastic modulus and loss elastic modulus, and the peak value thereof was defined as the glass transition temperature (°C).

### [Fracture toughness value]

With respect to each of the resin compositions of Examples 1 to 15 and Comparative Examples 1 and 2, the fused blend of resins and curing accelerator not containing the inorganic fillers was cast into a silicon mold and cured at 250 °C (200 °C in Comparative Examples 3 and 4). A test piece of 2 × 10 × 41.5 mm was prepared from the curing product, and the fracture toughness value (MN/m^{3/2}) thereof was measured in accordance with ASTM d5045-93.

### [Heat resistance under moisture absorption]

Each of the insulating material solutions obtained in accordance with the above procedures was agitated for five minutes by means of a planetary stirrer defoaming machine, applied onto a copper foil of 70 µm thickness so that the film thickness after thermobonding was about 100 µm, and dried at 100°C until the solvent was evaporated off. The copper foil coated with a film was superimposed on an aluminum alloy plate of 140 W/mk thermal conductivity and 2.0 mm thickness as a metal substrate with the coating film interposed therebetween, and thermobonded at 250°C (200°C in Comparative Examples 3 and 4) under a pressure of 20 MPa. The heat resistance under moisture absorption of the thus obtained circuit board laminate as a sample was evaluated by the following method.

A piece of size 40 × 40 mm was cut out from the laminate obtained in the above manner, and a land size of 20 × 20 mm was arranged on half of the sheet. The resultant piece was immersed in boiling water for an hour, and floated on a solder bath heated at 260 °C or 300 °C with the aluminum alloy side down for a period of 60 seconds or more. Visual check was made to find whether or not there was any delamination or blister in the circuit foil or insulating layer. Based on the visual check, evaluation mark C was given when any delamination or blister in the circuit foil or insulating layer was observed before 30 sec. floating time; evaluation mark B was given when any delamination or blister was observed within 60 sec. floating time; and evaluation mark A was given when no delamination or blister was observed even after the lapse of 60 sec. floating time.

**Table 1**

| Evaluation | Time until observation of delamination or blister |
|---|---|
| C | < 30 sec. |
| B | 30 - 60 sec. |
| A | > 60 sec. |

### [Solder connection reliability]

Each of the insulating material solutions obtained in accordance with the above procedures was agitated for five minutes by means of a planetary stirrer defoaming machine, applied onto a copper foil of 70 µm thickness so that the film thickness after thermobonding was about 100 µm, and dried at 100°C until the solvent was evaporated off. The copper foil coated with a film was superimposed on an aluminum alloy plate of 140 W/mk thermal conductivity and 2.0 mm thickness as a metal substrate with the coating film interposed therebetween, and thermobonded at 250°C (200°C in Comparative Examples 3 and 4) under a pressure of 20 MPa. The solder connection reliability of the thus obtained circuit board laminate as a sample was evaluated by the following method.

A piece of size 80 × 60 mm was cut out from the laminate obtained in the above manner. Two land sizes each of 2.0 × 1.8 mm were arranged at an interval of 2.0 mm on the piece, and a chip of size 3.2 × 1.6 mm was mounted by soldering in the fashion of bridging two lands. A cooling/heating cycle test of the chip-mounted piece was performed at from -40 to +150°C. The chip-mounted piece was taken out at 250 hour intervals, and the resistance of the chip was measured so as to check the conduction thereof, thereby determining the time until the resistance became immeasurable. Based on the test results, evaluation mark C was given when the resistance became immeasurable prior to the lapse of 500 hours; evaluation mark B was given when the resistance became immeasurable prior to the lapse of 1000 hours; and evaluation mark A was given when the resistance was measurable even after the lapse of 1000 hours.

**Table 2**

| Evaluation | Time until resistance became immeasurable |
|---|---|
| C | < 500 hours |
| B | 500 - 1000 hours |
| A | > 1000 hours |

The evaluation results are listed in Table 3.

**Table 3**

| | Composition | BACY: NCY (mass ratio) | | inorganic filler (65vol% *²) | | | | Curing accelerator | Glass trans ition temp | Fracture toughness value | Heat resistance under moisture absorption | | Solder connection reliability |
|---|---|---|---|---|---|---|---|---|---|---|---|---|---|
| | | BACY* ¹ | NCY*¹ | Alumina | Treated alumina | Boron nitride | Aluminum nitride | | | | 260°C | 300°C | |
| | | | | | | | | (1 mass% *³) | (°C) | (MN/m^{3/2}) | | | -40°C ⇔ 150°C |
| Ex. 1 | Comp. 1 | 3 | 1 | | | 32.5 | 32.5 | Phosphorus | 332 | 0.6 | A | A | A |
| Ex. 2 | Comp. 2 | 2 | 1 | | | 32.5 | 32.5 | Phosphorus | 345 | 0.6 | A | A | A |
| Ex. 3 | Comp. 3 | 1 | 1 | | | 32.5 | 32.5 | Phosphorus | 362 | 0.6 | A | A | A |
| Ex. 4 | Comp. 4 | 1 | 2 | | | 32.5 | 32.5 | Phosphorus | 377 | 0.6 | A | A | A |
| Ex. 5 | Comp. 5 | 1 | 3 | | | 32.5 | 32.5 | Phosphorus | 396 | 0.6 | A | A | A |
| Ex. 6 | Comp. 6 | 3 | 1 | 32.5 | | 32.5 | | Phosphorus | 292 | 0.6 | A | B | A |
| Ex. 7 | Comp. 7 | 3 | 1 | 32.5 | | 32.5 | | Nonphosphorus | 308 | 0.6 | A | A | A |
| Ex. 8 | Comp. 8 | 3 | 1 | | 32.5 | 32.5 | | Phosphorus | 325 | 0.6 | A | A | A |
| Ex. 9 | Comp. 9 | 3 | 1 | | 32.5 | 32.5 | | Nonphosphorus | 320 | 0.6 | A | A | A |
| Ex. 10 | Comp. 10 | 3 | 1 | | | 32.5 | 32.5 | Nonphosphorus | 330 | 0.6 | A | A | A |
| Ex. 11 | Comp. 11 | 5 | 1 | | | 32.5 | 32.5 | Phosphorus | 326 | 0.6 | A | A | A |
| Ex. 12 | Comp. 12 | 7 | 1 | | | 32.5 | 32.5 | Phosphorus | 319 | 0.6 | A | A | A |
| Ex. 13 | Comp. 13 | 9 | 1 | | | 32.5 | 32.5 | Phosphorus | 311 | 0.6 | A | A | A |
| Ex. 14 | Comp. 14 | 11 | 1 | | | 32.5 | 32.5 | Phosphorus | 308 | 0.6 | A | B | A |
| Comp. Ex. 1 | Comp. 1R | 1 | 0 | | | 32.5 | 32.5 | Phosphorus | 297 | 0.7 | A | C | A |
| Comp. Ex. 2 | Comp. 2R | 0 | 1 | | | 32.5 | 32.5 | Phosphorus | >400*⁵ | 0.4 | A | C | C |
| Comp. Ex. 3 *⁴ | Comp. 1 | 3 | 1 | | | 32.5 | 32.5 | Phosphorus | *6 | *6 | C | C | C |
| Comp. Ex. 4 *⁴ | Comp. 3 | 1 | 1 | | | 32.5 | 32.5 | Phosphorus | *6 | *6 | C | C | C |

| | | | | | | | | | | | | | |
|---|---|---|---|---|---|---|---|---|---|---|---|---|---|
| *1 BACY: bisphenol Acyanate resin, NCY: novolac cyanate resin *2 Based on the total volume of resins (BACY+NCY) *3 Based on the total mass of resins (BACY+NCY) *4 Copolymer of BACY and NCY was not satisfactory. *5 Upper limit value of the temperature range in which no pyrolysis occurred was indicated because Tg was not observed by measurement within the temperature range in which no pyrolysis occurred. *6 Immeasurable because of poor strength. | | | | | | | | | | | | | |

### Explanation of references

1:circuit board laminate, 1' :metal base circuit board, 2:metal board, 3:insulating layer, 4:metal foils, 4':circuit pattern, 100:power module, 11: power device, 12: solder layer, 13: metal base circuit board, 13a: circuit pattern, 13b: insulating layer, 13c:metal board, 14:exoergic seat, 15:heat sink, 200: traditional power module, 21:power device, 22: first solder layer, 23: circuit pattern, 24:ceramic board, 25:metalized layer, 26: second solder layer, 27:metal board, 28:exoergic seat, 29:heat sink

## Claims

1. A circuit board laminate (1) comprising a metal substrate (2), an insulating layer (3) disposed on at least one surface of the metal substrate (2) and a metal foil (4) disposed on the insulating layer (3), wherein the insulating layer (3) comprises an inorganic filler, **characterized in that** the insulating layer comprises a crosslinked copolymer consisting of bisphenol cyanate resin and novolac cyanate resin, and a curing accelerator, wherein the bisphenol cyanate resin and the novolac cyanate resin are contained in the insulating layer (3) in a mass ratio of 11:1 to 1:3.

2. The circuit board laminate (1) according to claim 1,**characterized in that** the curing accelerator is a borate complex, and that at least one member selected from the group consisting of alumina, surface-treated alumina, aluminum nitride and boron nitride is contained as the inorganic filler.

3. The circuit board laminate (1) according to claim 2, **characterized in that** the curing accelerator is a phosphorus borate complex, and that at least one member selected from the group consisting of surface-treated alumina, aluminum nitride and boron nitride is contained as the inorganic filler.

4. The circuit board laminate (1) according to claim 3, **characterized in that** two or more members selected from the group consisting of surface-treated alumina, aluminum nitride and boron nitride are contained as the inorganic filler.

5. The circuit board laminate (1) according to claim 2, **characterized in that** the curing accelerator is a nonphosphorus borate complex, and that at least one member selected from the group consisting of alumina, surface-treated alumina, aluminum nitride and boron nitride is contained as the inorganic filler.

6. The circuit board laminate (1) according to claim 5, **characterized in that** two or more members selected from the group consisting of alumina, surface-treated alumina, aluminum nitride and boron nitride are contained as the inorganic filler.

7. A metal base circuit board (13) obtained by patterning the metal foil (4) included in the circuit board laminate (1) according to any of claims 1 and 2 to 6.

8. A power module (100) comprising the metal base circuit board (13) according to claim 7.

## Patentansprüche

1. Leiterplattenlaminat (1), ein Metallsubstrat (2), eine Isolierschicht (3), die auf mindestens einer Oberfläche des Metallsubstrats (2) angeordnet ist, und eine Metallfolie (4) umfassend, die auf der Isolierschicht (3) angeordnet ist, wobei die Isolierschicht (3) einen anorganischen Füllstoff umfasst, **dadurch gekennzeichnet, dass** die Isolierschicht ein vernetztes Copolymer, das aus Bisphenol-Cyanat-Harz und Novolac-Cyanat-Harz besteht, und einen Aushärtebeschleuniger umfasst, wobei das Bisphenol-Cyanat-Harz und das Novolac-Cyanat-Harz in der Isolierschicht (3) in einem Massenverhältnis von 11:1 bis 1:3 enthalten sind.

2. Leiterplattenlaminat (1) nach Anspruch 1, **dadurch gekennzeichnet, dass** der Aushärtebeschleuniger ein Boratkomplex ist, und dass mindestens ein Element, das aus der Gruppe ausgewählt ist, die aus Aluminiumoxid, oberflächenbehandeltem Aluminiumoxid, Aluminiumnitrid und Bornitrid besteht, als der anorganische Füllstoff enthalten ist.

3. Leiterplattenlaminat (1) nach Anspruch 2, **dadurch gekennzeichnet, dass** der Aushärtebeschleuniger ein Phosphor-Borat-Komplex ist, und dass mindestens ein Element, das aus der Gruppe ausgewählt ist, die aus oberflächenbehandeltem Aluminiumoxid, Aluminiumnitrid und Bornitrid besteht, als der anorganische Füllstoff enthalten ist.

4. Leiterplattenlaminat (1) nach Anspruch 3, **dadurch gekennzeichnet, dass** zwei oder mehr Elemente, die aus der Gruppe ausgewählt sind, die aus oberflächenbehandeltem Aluminiumoxid, Aluminiumnitrid und Bornitrid besteht, als der anorganische Füllstoff enthalten sind.

5. Leiterplattenlaminat (1) nach Anspruch 2, **dadurch gekennzeichnet, dass** der Aushärtebeschleuniger eine nicht phosphorhaltiger Borat-Komplex ist, und dass mindestens ein Element, das aus der Gruppe ausgewählt ist, die aus Aluminiumoxid, oberflächenbehandeltem Aluminiumoxid, Aluminiumnitrid und Bornitrid besteht, als der anorganische Füllstoff enthalten ist.

6. Leiterplattenlaminat (1) nach Anspruch 5, **dadurch gekennzeichnet, dass** zwei oder mehr Elemente, die aus der Gruppe ausgewählt sind, die aus Aluminiumoxid, oberflächenbehandeltem Aluminiumoxid, Aluminiumnitrid und Bornitrid besteht, als der anorganische Füllstoff enthalten sind.

7. Metallbasis-Leiterplatte (13), die durch Strukturieren der Metallfolie (4) erhalten ist, die in dem Leiterplattenlaminat (1) nach einem der Ansprüche 1 und 2 bis 6 enthalten ist.

8. Leistungsmodul (100), die Metallbasis-Leiterplatte (13) nach Anspruch 7 umfassend.

## Revendications

1. Stratifié pour carte de circuit imprimé (1) comprenant un substrat métallique (2), une couche isolante (3) disposée sur au moins une surface du substrat métallique (2) et une feuille métallique (4) disposée sur la couche isolante (3), dans lequel la couche isolante (3) comprend une charge inorganique, **caractérisé en ce que** la couche isolante comprend un copolymère réticulé constitué d'une résine de cyanate de bisphénol et d'une résine de cyanate de novolaque, et un accélérateur de durcissement, où la résine de cyanate de bisphénol et la résine de cyanate de novolaque sont contenues dans la couche isolante (3) dans un rapport massique allant de 11:1 à 1:3.

2. Stratifié pour carte de circuit imprimé (1) selon la revendication 1, **caractérisé en ce que** l'accélérateur de durcissement est un complexe de borate, et **en ce qu'**au moins un élément choisi dans le groupe constitué d'alumine, d'alumine traitée en surface, de nitrure d'aluminium et de nitrure de bore est contenu comme étant la charge inorganique.

3. Stratifié pour carte de circuit imprimé (1) selon la revendication 2, **caractérisé en ce que** l'accélérateur de durcissement est un complexe de borate de phosphore, et **en ce qu'**au moins un élément choisi dans le groupe constitué d'alumine traitée en surface, de nitrure d'aluminium et de nitrure de bore est contenu comme étant la charge inorganique.

4. Stratifié pour carte de circuit imprimé (1) selon la revendication 3, **caractérisé en ce que** deux éléments ou plus choisis dans le groupe constitué d'alumine traitée en surface, de nitrure d'aluminium et de nitrure de bore sont contenus comme étant la charge inorganique.

5. Stratifié pour carte de circuit imprimé (1) selon la revendication 2, **caractérisé en ce que** l'accélérateur de durcissement est un complexe de borate non phosphoreux, et **en ce qu'**au moins un élément choisi dans le groupe constitué d'alumine, d'alumine traitée en surface, de nitrure d'aluminium et de nitrure de bore est contenu comme étant la charge inorganique.

6. Stratifié pour carte de circuit imprimé (1) selon la revendication 5, **caractérisé en ce que** deux éléments ou plus choisis dans le groupe constitué d'alumine, d'alumine traitée en surface, de nitrure d'aluminium et de nitrure de bore sont contenus comme étant la charge inorganique.

7. Carte pour circuit imprimé à base de métal (13) obtenue en formant des motifs sur la feuille métallique (4) incluse dans le stratifié pour carte de circuit imprimé (1) selon l'une des revendications 1 et 2 à 6.

8. Module d'alimentation (100) comprenant la carte de circuit imprimé à base de métal (13) selon la revendication 7.
